# EUROPÄISCHE PATENTANMELDUNG

(11) **EP 3 112 495 A1**
(43) Veröffentlichungstag der Anmeldung: **04.01.2017**
(21) Anmeldenummer: 16001119.3
(22) Anmeldetag: 17.05.2016
(51) Int. Cl.: C23C 4/134, C23C 4/137, B05B 15/04, B05B 13/02

(54) **ANORDNUNG SOWIE VERFAHREN ZUM BESCHICHTEN VON WERKSTÜCKEN**

(30) Priorität: 03.07.2015 CH 9692015
(71) Anmelder: AMT AG, 5312 Döttingen (CH)
(72) Erfinder: Keller, Silvano, CH-5315 Böttstein (CH); Herber, Ralph, DE-79713 Bad Säckingen (DE)
(74) Vertreter: Rottmann, Maximilian

(57) **Zusammenfassung**

Die Anordnung (1) zum Beschichten von Werkstücken (32) umfasst eine Behandlungskammer (1) mit einem darin angeordneten Handhabungsgerät (24). Das Handhabungsgerät (24) trägt eine Beschichtungsvorrichtung (25) zum Beschichten der Werkstücke (32). Die in der Form eines Tanks (1a) ausgebildete Behandlungskammer (1) ist auf der Oberseite mit einer Absaugöffnung (3) zum Absaugen von heissen Gasen und/oder Beschichtungspartikeln versehen. Im Innenraum der Behandlungskammer (1) ist eine Abzugshaube (33) zum Kanalisieren der abzusaugenden Gase in Richtung der Absaugöffnung (3) angeordnet ist. Die Abzugshaube (33) ist zusammen mit der Werkstückaufnahme (29) auf einer verschiebbaren Plattform (16) angeordnet. Die Plattform (16) ist zusammen mit der Abzugshaube (33) und der Werkstückaufnahme (29) aus der Behandlungskammer (1) herausziehbar bzw. in die Behandlungskammer (1) hineinschiebbar. Die Abzugshaube (33) ist derart auf der Plattform (16) angeordnet, däss im hineingeschobenen Zustand der Plattform (16) die Abzugshaube mit der Absaugöffnung (3) gekoppelt ist.

## Beschreibung

Die Erfindung betrifft eine Anordnung sowie ein Verfahren zum Beschichten von Werkstücken gemäss dem Oberbegriff des Anspruchs 1 bzw. 12. Mittels derartigen Anordnungen können Werkstücke -Substrate- in einer definierten Atmosphäre beschichtet werden. Als Beispiel für eine solche Anordnung sei eine sogenannte "VPS-Anlage" "Vakuum Plasma Spray Anlage" genannt. Bei solchen Anlagen werden die Werkstücke in einer weitgehend evakuierten Behandlungskammer "Unterdruckkammer" mittels eines Plasmaspritzgeräts beschichtet. Ggf. wird in die Behandlungskammer nach deren Evakuieren ein auf den Beschichtungsprozess abgestimmtes Gas, beispielsweise ein inertes oder reaktives Gas eingelassen.

Um die während des Beschichtens eines Werkstücks durch den Beschichtungsstrahl in die Behandlungskammer eingeleiteten Gase zu entfernen, werden die Gase bei bekannten Anordnungen stirnseitig aus der Behandlungskammer abgesaugt. Derartig Anordnungen haben den Nachteil, dass die heissen Gase das in der Behandlungskammer angeordnete Handhabungsgerät thermisch sehr stark belasten, wobei die Behandlungskammer durch nicht aufgetragene Beschichtungspartikel -Oversprayzusätzlich stark verschmutzt wird.

Um den Overspray aufzufangen und/oder zu kanalisieren ist es bekannt, in der Behandlungskammer eine Abzugshaube anzuordnen. Eine solche Abzugshaube wird üblicherweise oberhalb oder hinter der Werkstückaufnahme angeordnet. Die Abzugshaube ist insbesondere dann besonders wirkungsvoll, wenn diese nahe an der die zu beschichtenden Werkstücke tragenden Werkstückaufnahme angeordnet ist oder diese gar teilweise umschliesst. Allerdings kann eine fest in der Behandlungskammer angeordnete Abzugshaube beim Bestücken der Werkstückaufnahme hinderlich sein.

Aus der EP 1 013 791 A ist eine gattungsgemässe Anordnung für eine mit einer Behandlungskammer und einem darin angeordneten Plasmaspritzgerät versehene Plasmaspritzanlage bekannt. Vertikal unterhalb der Behandlungskammer ist ein Sammelschacht angeordnet. Im Übergangsbereich von der Behandlungskammer zu dem Sammelschacht ist eine Ablenkeinrichtung angeordnet, die eine Mehrzahl strömungsablenkender Leitbleche aufweist. Das Plasmaspritzgerät ist derart in der Kammer angeordnet, dass dessen Beschichtungsstrahl nach unten gegen die Ablenkeinrichtung gerichtet ist. Bei dieser Anordnung werden die Gase über die Sammelkammer nach unten aus der Behandlungskammer abgesaugt, während die gereinigten Gase über eine weitere Leitung von oben in die Behandlungskammer zurückgeführt werden können.

Aus der DE 600 03 558 T2 geht eine Vorrichtung zum Aufbringen von Quarzsand auf eine Vorform hervor. Aus der Vorform wird in nachfolgenden Schritten eine optische Faser hergestellt. Die Vorrichtung weist eine Umhüllungsvorrichtung mit einer Plasmakammer auf. Die Plasmakammer ist mit einer Abzugshaube versehen, über welche heisse Luft und Kieselsäuredämpfe entfernt werden können. In der Plasmakammer sind zwei Plasmabrenner angeordnet. Die Plasmabrenner dienen dem Aufschmelzen des Quarzsandes, welcher über einen Röhreninjektor zugeführt und in der Plasmaflamme aufgeschmolzen wird. Der geschmolzene Quarzsand wird auf die sich drehende Vorform aufgebracht, bis ein vorgegebener Durchmesser erreicht ist. Die Plasmakammer ist auf der Oberseite mit einer Abzugshaube zum Absaugen von Luft und Kieselsäuredämpfen versehen ist.

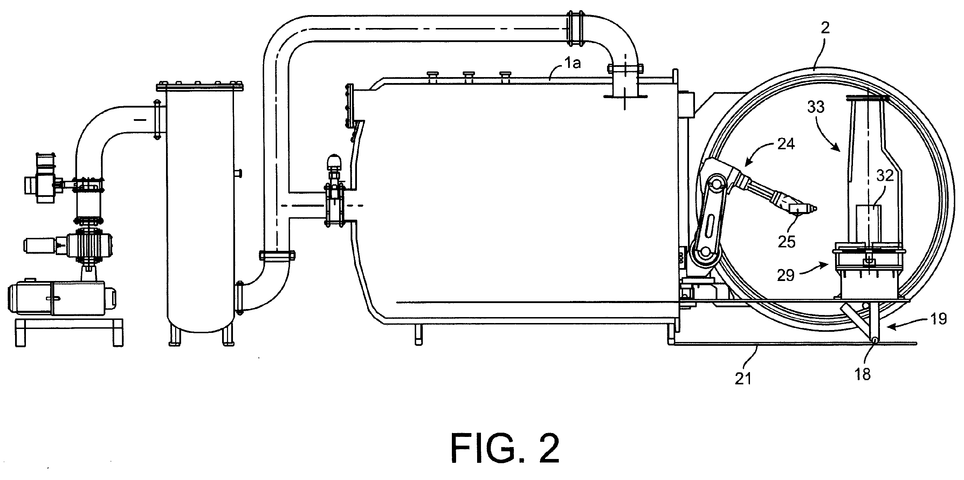

Die DE 693 07 796 T2 offenbart ein Verfahren und eine Vorrichtung zum Beschichten von Substraten mittels Plasmasprühen. Die Vorrichtung weist gemäss Fig. 2 eine Sprühkammer auf, in der eine Plasmapistole an einem Roboterarm befestigt ist. Das zu beschichtende Substrat ist auf einem Drehtisch angeordnet. Zum Auffangen des Oversprays ist eine Sprühhaube vorgesehen, die mit einem Staubsammler verbunden ist. Die Sprühhaube ist hinter dem Drehtisch angeordnet.

Die US 2,461,657 A zeigt eine Beschichtungsvorrichtung mit einem drehbaren Tisch und einer hinter dem Tisch angeordneten Abzugshaube. Auf dem Tisch kann eine Mehrzahl von Werkstücken angeordnet werden.

In der DE 10 2004 037 808 A1 ist eine Absaugvorrichtung offenbart, deren Haube mittels Schrauben an einem Flansch befestigt ist.

Schliesslich zeigt die DE 35 20 924 A1 eine Plasmaanlage mit einem Vakuumtank und einer verfahrbaren Tragvorrichtung, welche in den Tank eingefahren und aus diesem herausgefahren werden kann.

Aufgabe der Erfindung ist es, eine dem eingangs genannten technischen Gebiet zugehörende Anordnung zum Beschichten von Werkstücken zu schaffen, bei welcher einerseits die thermische Belastung des Handhabungsgeräts wie auch die Verschmutzung des Handhabungsgeräts und des Vakuumtanks gering gehalten werden sollen und andererseits ein einfaches beladen und entladen der Werkstückaufnahme ermöglicht werden soll.

Die Lösung der Aufgabe ist durch die Merkmale des Anspruchs 1 definiert. Gemäss der Erfindung ist im Innenraum der Behandlungskammer eine Abzugshaube zum Kanalisieren der abzusaugenden Gase in Richtung der Absaugöffnung angeordnet, wobei zumindest die Abzugshaube zusammen mit der Werkstückaufnahme auf einer verschiebbaren Plattform angeordnet sind, mittels welcher die Abzugshaube zusammen mit der Werkstückaufnahme aus dem Tank herausziehbar bzw. in den Tank hineinschiebbar ist, und wobei die Abzugshaube derart auf der Plattform angeordnet ist, dass im hineingeschobenen Zustand der Plattform die Abzugshaube mit der Absaugöffnung gekoppelt ist.

Die Abzugshaube bewirkt, dass die heissen Gase zusammen mit den nicht aufgetragenen Beschichtungspartikeln (Overspray) gezielt zu der Absaugöffnung geleitet werden, während die verschiebbare Plattform das Bestücken und Entladen der Werkstückaufnahme begünstigt.

Indem die Gase mittels der Abzugshaube kanalisiert und gezielt zu der Absaugöffnung geleitet werden, kann die thermische Belastung des Handhabungsgeräts wie auch die Verschmutzung des Tanks tief gehalten werden. Dadurch können hohe Beschichtungsleistungen erzielt und die Kosten tief gehalten werden. Indem die Abzugshaube zusammen mit der Werkstückaufnahme auf einer verschiebbaren Plattform angeordnet sind, mittels welcher die Abzugshaube zusammen mit der Werkstückaufnahme aus dem Tank herausziehbar bzw. in den Tank hineinschiebbar ist, kann zudem das Be- und Entladen der Werkstückaufnahme vereinfacht werden, da die Werkstückaufnahme ausserhalb des Tanks einfacher als innerhalb des Tanks mit Werkstücken beladen/bestückt werden kann.

Gemäss einer bevorzugten Weiterbildung ist die Absaugöffnung auf der Oberseite der Behandlungskammer angeordnet. Dadurch können die heissen Gase nach oben aus der Behandlungskammer abgeleitet werden, was im Hinblick auf eine möglichst geringe thermische Belastung des Handhabungsgeräts von Vorteil ist, zumal heisse Gase ohnehin die Tendenz haben aufzusteigen.

Vorzugsweise ist die Abzugshaube mit einer der Beschichtungsvorrichtung zugewandten Öffnung versehen. Über diese Öffnung können die Gase in das Innere der Abzugshaube einströmen.

Bei einer weiteren bevorzugten Weiterbildung ist die Abzugshaube auf der Oberseite mit einem Anschlussflansch zum Koppeln mit der Absaugöffnung versehen. Diese Ausbildung erlaubt ein einfaches und sicheres Ankoppeln der Abzugshaube an die Absaugöffnung.

Besonders bevorzugt ist die Werkstückaufnahme als drehbarer Tisch ausgebildet und mit Mitteln zum Fixieren eines oder mehrerer Werkstücke versehen, wobei die Abzugshaube drehfest auf der Plattform angeordnet ist. Diese Ausbildung erlaubt es, ein auf dem Tisch fixiertes Werkstück in Relation zu der Beschichtungsvorrichtung zu drehen, wobei sich durch die drehfeste Anordnung der Abzugshaube deren Öffnung in Relation zu der Beschichtungsvorrichtung nicht verändert.

Bei einer bevorzugten Weiterbildung ist die Abzugshaube in Bezug auf den Tisch derart angeordnet, dass das zu beschichtende Werkstück zwischen der Beschichtungsvorrichtung und der Eintrittsöffnung der Abzugshaube oder in der Abzugshaube hinter der Eintrittsöffnung auf dem Tisch der Werkstückaufnahme fixierbar ist. Dadurch wird erreicht, dass der Beschichtungsstrahl während des Beschichtens eines Werkstücks in Richtung des Innenraums der Abzugshaube gerichtet ist.

Eine bevorzugte Weiterbildung sieht vor, dass der Tisch der Werkstückaufnahme zur Aufnahme einer Mehrzahl von Werkstücken ausgebildet ist, welche entlang eines kreisringförmigen Aussenteils fixierbar sind, und dass die Abzugshaube drehfest und zentral innerhalb bzw. oberhalb des kreisringförmigen Aussenteils angeordnet ist. Diese Ausbildung erlaubt es, eine Vielzahl von Werkstücken auf dem Tisch zu fixieren und durch Drehen des Tischs nacheinander zu beschichten, wobei gleichzeitig sichergestellt ist, dass der Beschichtungsstrahl ins Innere der Abzugshaube gerichtet ist, da sich deren Öffnung in Relation zu der Beschichtungsvorrichtung nicht verändert.

Besonders bevorzugt ist die Behandlungskammer durch einen Tank gebildet, der mittels einer Vakuumpumpe evakuierbar ist. Ein Tank ist vergleichsweise günstig in der Herstellung und kann einfach an die spezifischen Bedürfnisse angepasst werden.

Eine weitere bevorzugte Weiterbildung sieht vor, dass die eine Stirnseite des Tanks als Türe ausgebildet ist, über welche die Plattform aus dem Tank herausziehbar bzw. in den Tank hineinschiebbar ist. Eine solche Türe ergibt eine grosse Öffnung, über welche die Plattform zusammen mit der Abzugshaube und der Werkstückaufnahme aus dem Tank herausziehbar bzw. in den Tank hineinschiebbar ist.

Vorzugsweise ist die Plattform auf einer Schiene verfahrbar abgestützt. Damit wird ein Verfahren der Plattform entlang einer vorgegebenen Wegstrecke ermöglicht, wobei das Vorsehen einer Schiene eine vergleichsweise einfache und kostengünstige Lösung ist.

Bei einer besonders bevorzugten Weiterbildung ist sowohl innerhalb wie auch ausserhalb der Behandlungskammer eine Schiene angeordnet, wobei die ausserhalb der Behandlungskammer angeordnete Schiene vertikal unterhalb der innerhalb der Behandlungskammer angeordneten Schiene verläuft, und wobei die Plattform einen mit Rollen versehenen Schwenkmechanismus aufweist, der beim Herausziehen der Plattform aus der Behandlungskammer derart nach unten schwenkt, dass die Rollen auf der ausserhalb der Behandlungskammer angeordneten Schiene aufzuliegen kommen. Da eine Behandlungskammer gegenüber dem Fussboden üblicherweise etwas erhöht ist, indem sie beispielsweise auf Füssen steht, verläuft auch der Boden der Behandlungskammer auf einer höheren Ebene als der Fussboden. Sofern innerhalb der Behandlungskammer und auf dem Fussboden Schienen zur Abstützung und ggf. Führung der Plattform angeordnet werden, so verlaufen diese auf unterschiedlichen Ebenen. Mittels des beanspruchten Schwenkmechanismus kann dieser Höhenunterschied ausgeglichen werden und die Plattform kann sich auch auf der ausserhalb der Behandlungskammer verlaufenden Schiene abstützen. Diese Ausbildung ermöglicht, die Plattform zusammen mit den daran angeordneten Elementen trotz des beschriebenen Höhenunterschieds der Schienen aus dem Tank herauszuziehen und ausserhalb der Behandlungskammer abzustützen. Vorzugsweise ist der Schwenkmechanismus derart ausgebildet, dass er beim Hereinschieben der Plattform automatisch hochschwenkt.

Eine weitere Aufgabe der Erfindung besteht darin, ein Verfahren zum Beschichten von Werkstücken in einer Behandlungskammer gemäss dem Oberbegriff des Anspruchs 12 vorzuschlagen, mittels welchem die thermische Belastung des Handhabungsgeräts gering gehalten werden kann, wobei zudem auch ein gutes Absaugen des Oversprays sichergestellt und ein einfaches beladen und entladen der Werkstückaufnahme ermöglicht werden soll.

Erfindungsgemäss wird dies dadurch erreicht, dass zum Be- und Entladen der Werkstückaufnahme die Plattform zusammen mit der Werkstückaufnahme und der Abzugshaube aus der Behandlungskammer herausgezogen wird, während die Abzugshaube beim Hineinschieben der Plattform mit der Absaugöffnung gekoppelt wird. Somit wird ein einfaches Be- und Entladen der Werkstückaufnahme ausserhalb der Behandlungskammer ermöglicht. Zudem kann die Abzugshaube dadurch vergleichsweise nahe an der Werkstückaufnahme angeordnet werden, da letztere im herausgezogenen Zustand der Plattform gut zugänglich ist. Da die Abzugshaube im hineingeschobenen Zustand der Plattform mit der Absaugöffnung gekoppelt wird, wird auch ein gutes Absaugen des Oversprays ermöglicht.

Vorzugsweise werden während des Beschichtens eines Werkstücks Gase über die Abzugshaube und die Absaugöffnung aus der Behandlungskammer abgesaugt. Dadurch kann sichergestellt werden, dass die thermische Belastung des Handhabungsgeräts gering gehalten wird und die Gase zusammen mit dem Overspray abgesaugt werden.

Bei einer besonders bevorzugten Weiterbildung des Verfahrens wird das zu beschichtende Werkstück derart auf dem Tisch angeordnet, dass beim Beschichten des jeweiligen Werkstücks der Beschichtungsstrahl zum Beschichten des Werkstücks überwiegend horizontal oder nach oben gerichtet ist. Dadurch wird eine gerichtete Gasströmung erzeugt, welche in Bezug auf Verschmutzung der Behandlungskammer wie auch der thermischen Belastung des Handhabungsgeräts besonders vorteilhaft ist. Besonders bevorzugt wird der Absaugvorgang spätestens mit dem Beginn eines Beschichtungsvorgangs gestartet, wobei in der Behandlungskammer während des gesamten Beschichtungsvorgangs eine kontinuierliche Gasströmung erzeugt wird, welche vom Kopf der Beschichtungsvorrichtung ausgehend in Richtung der Absaugöffnung gerichtet ist. Dadurch kann ein optimales Absaugen der nicht aufgetragenen Beschichtungspartikel erreicht werden.

Nachfolgend wird die Erfindung anhand von Zeichnungen näher erläutert. Dabei zeigt:
- Fig. 1: einen Schnitt durch ein erstes Ausführungsbeispiel der Anordnung;
- Fig. 2: einen weiteren Schnitt durch die Anordnung gemäss Fig. 1 mit geöffneter Behandlungskammertür;
- Fig. 3: einen Schnitt durch ein weiteres Ausführungsbeispiel der Anordnung;
- Fig. 4: Teile der Anordnung gemäss Fig. 3 in vergrösserter und perspektivischer Darstellung;
- Fig. 5: die Anordnung gemäss Fig. 3 während eines Beschichtungsvorgangs.

Grundsätzlich sind in den Figuren gleiche Teile mit gleichen Bezugszeichen versehen.

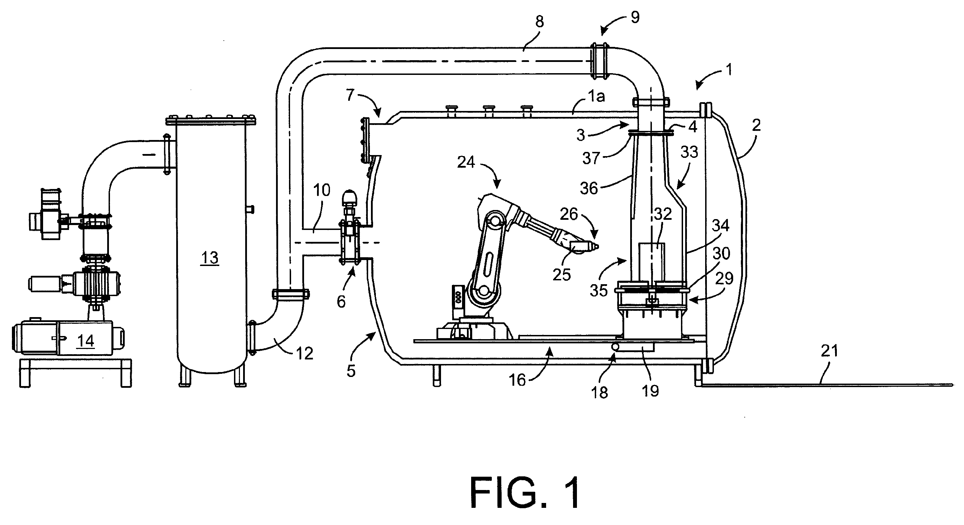

Die Figur 1 zeigt einen Schnitt durch die schematisch dargestellte Anordnung zusammen mit weiteren Komponenten. Die Anordnung umfasst eine Behandlungskammer 1 in der Form eines Tanks 1 a, dessen eine Stirnseite durch eine Türe 2 gebildet wird. Auf der Oberseite des Tanks 1 a ist eine Absaugöffnung 3 in der Form eines Flansches 4 in die Tankwandung eingelassen. Der Flansch 4 mündet über eine erste Absaugleitung 8 in eine Leitung 12, welche ihrerseits mit einer Filtervorrichtung 13 verbunden ist. In die der Tür 2 gegenüberliegende zweite Stirnseite 5 des Tanks 1 a ist ein weiterer Flansch 6 eingelassen, der über eine zweite Absaugleitung 10 in die mit der Filtervorrichtung 13 verbundene Leitung 12 mündet. An der Filtervorrichtung 13 ist eine Vakuumpumpe 14 angeschlossen. Sowohl in der ersten Absaugleitung 8 wie auch in der zweite Absaugleitung 10 ist je ein Absperrventil 9, 11 angeordnet. Die zweite Stirnseite 5 des Tanks 1a ist auf der Oberseite zudem mit einem zusätzlichen Flansch 7 versehen, der in diesem Ausführungsbeispiel keine Funktion hat, jedoch bei einem alternativen Ausführungsbeispiel zum Einsatz kommen kann, wie nachfolgend noch näher erläutert wird.

Die Anordnung verfügt des Weiteren über eine horizontal verfahrbare Plattform 16, welche in den Tank 1a hinein- wie auch herausfahrbar ist. Auf dieser Plattform 16 sind ein Handhabungsgerät 24, eine Werkstückaufnahme 29 und eine Abzugshaube 33 angeordnet. Das Handhabungsgerät 24 trägt eine Beschichtungsvorrichtung 25, welche mit einem einen Beschichtungsstrahl erzeugenden Spritzkopf 26 versehen ist. Als Beschichtungsvorrichtung 25 wird im vorliegenden Beispiel von einem Plasmaspritzgerät ausgegangen. Die zum Betrieb des Plasmaspritzgeräts notwendigen Leitungen für die Stromversorgung, die Plasmagase und das Beschichtungspulver sind nicht näher dargestellt. Das Plasmaspritzgerät 25 bzw. dessen Spritzkopf 26 ist mittels des Handhabungsgeräts 24 dreidimensional beweglich, so dass Werkstücke mit beliebigen Formen bzw. Oberflächen beschichtet werden können.

Wenn in der vorliegenden Schrift jeweils von Abzugshaube gesprochen wird, so ist darunter nicht nur eine Haube im eigentlichen Sinn zu verstehen, sondern der Begriff Abzugshaube steht stellvertretend für jegliche Form von Ablenk-, Umlenk-, Auffang-, Sammel- oder Kanalisierungseinrichtung, mittels welcher Gase und/oder nicht aufgetragene Beschichtungspartikel -Overspray- abgelenkt und/oder umgelenkt und/oder aufgefangen und/oder gesammelt und/oder kanalisiert werden kann/können.

Die Plattform 16 ist auf der Unterseite mit einer Vielzahl von Rollen versehen, welche innerhalb des Tanks 1a in einer Schiene geführt sind, wie nachfolgend noch näher erläutert wird. In dieser Darstellung ist nur eine von zwei vorderen Rollen 18 erkennbar, welche mittels eines im Bereich des vorderen Endes der Plattform 16 abgeordneten Schwenkmechanismus 19 derart an der Plattform 16 befestigt sind, dass sie beim Herausfahren der Plattform 16 aus dem Tank 1a nach unten auf die Höhe einer vor dem Tank 1a verlaufenden Schiene 21 schwenkbar sind. Der Schwenkmechanismus 19 verriegelt sich beim Herausfahren der Plattform aus dem Tank 1 a selbsttätig.

Auf der Plattform 16 ist die in Form eines drehbaren Tisches 30 ausgebildete Werkstückaufnahme 29 angeordnet. Auf der Oberseite des Tischs 30 sind Befestigungsmittel zum Fixieren eines oder ggf. mehrerer Werkstücke -Substrateangeordnet, wobei die Befestigungsmittel nicht dargestellt sind. Im vorliegenden Beispiel ist ein mittig auf dem Tisch 30 fixiertes Werkstück 32 dargestellt. Die Abzugshaube 33 ist zentral auf oder oberhalb des Tisches 30 angeordnet, wobei die Abzugshaube 33 drehfest angeordnet ist, sich also nicht mit dem Tisch 30 zusammen dreht. Die das Werkstück 32 teilweise umschliessende Abzugshaube 33 dient dazu, den Beschichtungsstrahl hinter dem Werkstück 32 zu Kanalisieren und nach oben in Richtung der Absaugöffnung 3 umzuleiten. Im Innern der Abzugshaube 33 können ggf. Umlenk- bzw. Ablenkbleche oder Auffangbleche angeordnet sein. Die Abzugshaube 33 ist mit einer dem Plasmaspritzgerät 25 bzw. dem Handhabungsgerät 24 zugewandten Öffnung 35 versehen, welche eine Eintrittsöffnung für den Beschichtungsstrahl bildet. Über diese Öffnung 35 können der Beschichtungsstrahl und damit die aus dem Brennerkopf 26 austretenden Gase ins Innere der Abzugshaube 33 einströmen.

Der Unterteil 34 der Abzugshaube 33 ist rechteckig ausgebildet, wobei drei Seiten das Werkstück 32 umfassen, während die vierte Seite die Öffnung 35 bildet. Den Oberteil der Abzugshaube 33 bildet ein rohrförmiger Fortsatz 36, der am oberen Ende mit einem Flansch 37 versehen ist, der auf den Flansch 4 der Absaugöffnung 3 abgestimmt ist. Im hier gezeigten eingeschobenen Zustand der Plattform 16 fluchtet der Flansch 4 der Absaugöffnung 3 mit dem Flansch 37 der Abzugshaube 33, d.h. die beiden Flansche 4, 37 verlaufen koaxial zueinander.

Im vollständig eingeschobenen Zustand der Plattform 16 besteht zwischen den beiden Flanschen 4, 37 ein kleiner Spalt, beispielsweise in der Grössenordnung von ca. 0.5 bis 2 mm. Vorzugsweise weisen die beiden Flansche 4, 37 eine kreisringförmig umlaufende Stirnseite mit einer Kreisringbreite von einigen Zentimetern auf, so dass durch den vergleichsweise breiten Spalt und die damit einhergehende Drosselwirkung kaum Gase über diesen Spalt angesaugt werden. Auch wenn noch ein kleiner Spalt zwischen den beiden Flanschen 4, 37 besteht, so kann doch davon gesprochen werden, dass die Abzugshaube 33 mit der Absaugöffnung 3 gekoppelt ist. Jedenfalls ist unter einer Kopplung zwischen der Abzugshaube 33 und der Absaugöffnung 3 zu verstehen, dass Gase, Overspraypartikel und dergleichen über die Abzugshaube 33 in die Absaugöffnung 3 einströmen und von dort aus dem Tank 1a abgesaugt werden können. Sollte jedoch eine dichte bzw. dichtere Verbindung zwischen den beiden Flanschen 4, 37 gewünscht werden, so bieten sich verschiedene Möglichkeiten an. So kann in die Stirnseite des einen und/oder anderen Flansches 4, 37 eine wärmebeständige, elastische Dichtung eingelassen werden. Alternativ oder zusätzlich kann die Plattform 16 derart ausgebildet sein, dass sie am Ende des Einschiebevorgangs eine vertikale Hubbewegung ausführt, welche bewirkt, dass die beiden Flansche 4, 37 aneinander zu liegen kommen. Eine weitere Alternative kann darin bestehen, dass die Plattform 16 im Innern des Tanks 1a auf einer Schiene verfahrbar abgestützt ist, welche von vorne nach hinten d.h. von der Tür 2 her in Richtung des Inneren des Tanks 1a, leicht ansteigt, so dass im eingeschobenen Zustand der Plattform 16 der Flansch 37 der Abzugshaube 33 ebenfalls dichtend an dem Flansch 4 der Absaugöffnung 3 zur Anlage kommt. Schliesslich könnten die einander zugewandten Stirnseiten der Flansche 4, 37 auch derart schräg verlaufend ausgebildet sein, dass sie sich aneinander anlegen, sobald die Plattform 16 vollständig eingeschoben ist, wobei vorgängige Beispiele nicht als abschliessend zu betrachten sind.

Die Fig. 2 zeigt die Anordnung gemäss Fig. 1, wobei die Türe 2 des Tanks 1a geöffnet ist und die Plattform 16 zusammen mit den darauf angeordneten Elementen 24, 25, 29, 32, 33 aus dem Tank 1a herausgefahren ist/sind. In dieser Darstellung ist erkennbar, dass der Schwenkmechanismus 19, der die vorderen Rollen 18 trägt, heruntergeklappt ist. Die vorderen Rollen 18 liegen nun auf der ausserhalb des Tanks 1 a angeordneten Schiene 21 auf. Bei geöffneter Tür 2 und herausgefahrener Plattform 16 können beispielsweise zu beschichtende Werkstücke 32 auf dem Tisch der Werkstückaufnahme 29 befestigt oder beschichtete Werkstücke entnommen werden. Der rückwärtige Teil der Plattform 16 stützt sich jedoch weiter auf der innerhalb des Tanks 1 a verlaufenden Schiene ab. Vorzugsweise ist der Schwenkmechanismus 19 derart ausgebildet, dass er beim Hereinschieben der Plattform 16 automatisch hochschwenkt.

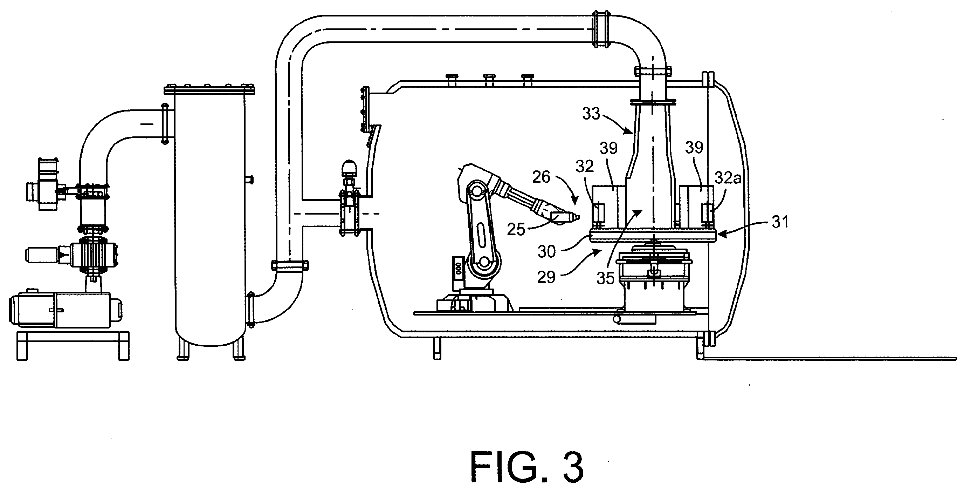

Die Fig. 3 zeigt einen Schnitt durch ein alternatives Ausführungsbeispiel der Anordnung. In diesem Beispiel wird die Werkstückaufnahme 29 durch einen runden Tisch 30 gebildet, der mit einem kreisringförmigen, als Rotor ausgebildeten Aussenteil 31 versehen ist, der zur Aufnahme einer Mehrzahl von Werkstücken 32, 32a ausgebildet ist. Der Tisch weist einen als Stator ausgebildeten Mittelteil auf, auf dem die Abzugshaube 33 angeordnet ist. Die Abzugshaube 33 weist wiederum eine dem Plasmaspritzgerät 25 zugewandte Öffnung 35 auf, über welche die aus dem Brennerkopf 26 austretenden Gase ins Innere der Abzugshaube 33 einströmen und abgesaugt werden können. Zwischen den einzelnen Werkstücken 32, 32a sind Abschirmbleche 39 angeordnet, auf die nachfolgend noch näher eingegangen wird.

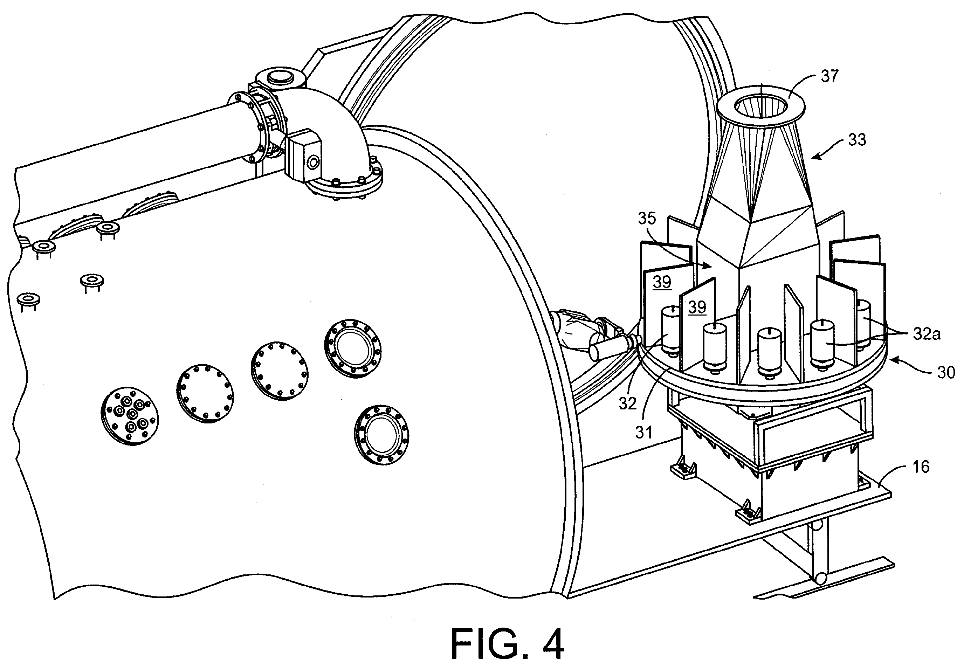

Die Fig. 4 zeigt Teile der Anordnung gemäss Fig. 3 in vergrösserter und perspektivischer Darstellung. Dazu ist der Vorderteil der Plattform 16 im herausgezogenen Zustand dargestellt. In dieser Darstellung ist erkennbar, dass die Werkstücke 32, 32a auf dem kreisringförmigen Aussenteil 31 des Tischs 30 gleichmässig verteilt angeordnet sind. Zudem sind die Abschirmbleche 39 ersichtlich, welche verhindern sollen, dass die neben dem jeweils zu beschichtenden Werkstück 32 positionierten Werkstücke 32a "mitbeschichtet" werden, namentlich durch abgelenkte Pulverpartikel. Durch die beiden das jeweilige Werkstück 32, 32a flankierenden Abschirmbleche 39 wird der Beschichtungsstrahl in Richtung der Öffnung 35 der Abzugshaube 33 gelenkt bzw. kanalisiert. Der am oberen Ende der Abzugshaube 33 angeordnete Flansch 37 zusammen mit seinem breiten Rand ist ebenfalls erkennbar.

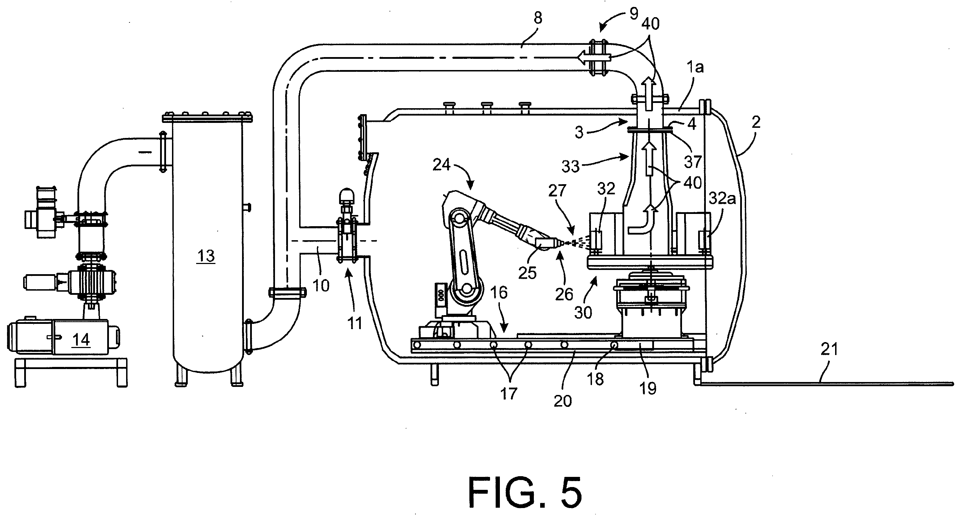

Die Fig. 5 zeigt die Anordnung gemäss Fig. 3 während eines Beschichtungsvorgangs. Während des Beschichtens eines Werkstücks 32 ist die Vakuumpumpe 14 in Betrieb, so dass über die Abzugshaube 33 und die erste Absaugleitung 8 Gase zusammen mit nicht aufgetragenen Beschichtungspartikeln aus dem Tank 1a abgesaugt werden. Vorzugsweise wird die Vakuumpumpe 14 spätestens mit dem Beginn des eigentlichen Beschichtungsvorgangs eingeschaltet, so dass von Anfang an über die Abzugshaube 33 abgesaugt wird. Dazu ist das in der ersten Absaugleitung 8 angeordnete Ventil 9 geöffnet, während das in der zweiten Absaugleitung 9 angeordnete Ventil 11 geschlossen ist. Der aus dem Spritzkopf 26 des Plasmaspritzgeräts 25 austretende Beschichtungsstrahl 27 ist andeutungsweise eingezeichnet. Mittels Pfeilen 40 wird die Gasströmung innerhalb der Abzugshaube 33 symbolisiert. Jedenfalls werde die Gase des Beschichtungsstrahls 27 hinter dem zu beschichtenden Werkstück 32 durch die Abzugshaube 33 aufgefangen, kanalisiert und nach oben in Richtung der Absaugöffnung 3 umgeleitet.

Um die Verschmutzung des Tanks 1 a möglichst gering zu halten, wird bei dem Beschichtungsvorgang darauf geachtet, dass der Beschichtungsstrahl 27 möglichst horizontal oder ggf. leicht nach oben gerichtet ist, so dass die Gase zusammen mit dem Overspray direkt in die Abzugshaube 33 gelangen. Um dies zu ermöglichen, werden die zu beschichtenden Werkstücke 32. 32a derart auf dem Tisch 30 der Werkstückaufnahme angeordnet, dass eine Beschichtung weitestgehend mit einem horizontal oder ggf. leicht nach oben gerichteten Beschichtungsstrahl 27 ermöglicht wird. Es versteht sich, dass dazu die Steuerung des Handhabungsgeräts 24 entsprechend angepasst wird.

In dieser Darstellung ist zudem eine Vielzahl von Rollen 17 erkennbar, mittels welchen die Plattform 16 innerhalb des Tanks 1a auf einer Schiene 20 verfahrbar abgestützt ist. Da die vor dem Tank 1a angeordnete Schiene 21 unterhalb der im Tank 1a angeordneten Schiene 20 verläuft, sind die beiden vorderen Rollen 18 in der vorgängig beschriebenen Weise mittels des Schwenkmechanismus 19 an der Plattform 16 befestigt, wobei sie hier im eingeklappten Zustand dargestellt sind.

Ein Beschichtungsvorgang mit der gezeigten Anordnung läuft beispielsweise folgendermassen ab. Im herausgefahrenen Zustand der Plattform (Fig. 2) wird zumindest ein zu beschichtendes Werkstück 32 auf dem Tisch 30 der Werkstückaufnahme 29 befestigt. Danach wird die Plattform 16 in die Behandlungskammer 1 hineingefahren, was manuell oder beispielsweise elektromotorisch erfolgen kann. Beim Hereinschieben der Plattform 16 wird der Flansch 37 der Abzugshaube 33 an den Flansch 4 der Absaugöffnung 3 herangeführt, so dass die beiden Flansche 4, 37 koaxial zueinander zu liegen kommen und die Abzugshaube 33 mit der Absaugöffnung 3 gekoppelt ist. Danach wird die Tür 2 des Tanks 1a geschlossen (Fig. 1) und der Tank 1a mittels der Vakuumpumpe 14 evakuiert. Das Evakuieren kann über die erste und/oder zweite Absaugleitung 8, 10 erfolgen, was mittels den beiden Ventilen 9, 11 bestimmt wird. Nachdem ein vorgegebener Unterdruck im Tank 1a erreicht ist, beispielsweise 1 mbar, wird ein Gas, beispielsweise ein inertes Gas wie Argon, in den Tank 1a eingelassen, bis ein Maximaldruck, beispielsweise 50 mbar, erreicht ist. Die zum Zuführen eines solchen Inertgases notwendigen Mittel sind nicht näher dargestellt. Vor dem eigentlichen Beschichtungsvorgang wird das Werkstück 32 ggf. erhitzt, was beispielsweise mittels der Beschichtungsvorrichtung 25 erfolgen kann, indem dazu deren Strahl -Plasmastrahlgenutzt wird. Es versteht sich, dass während des Erhitzens des Werkstücks 32 kein Beschichtungspulver zugeführt wird.

Nach dem Erhitzen des Werkstücks 32 kann ein Beschichtungsvorgang gestartet werden, indem das Beschichtungsmaterial, welches vorzugsweise als Pulver zugeführt wird, mittels der Beschichtungsvorrichtung 25 aufgeschmolzen und mittels eines Beschichtungsstrahls auf das Werkstück 32 aufgetragen wird. Während des Beschichtungsvorgangs werden Gase über die Absaugöffnung 3 und die erste Absaugleitung 8 aus dem Tank 1a abgesaugt. Die Abzugshaube 33 ist dazu derart positioniert und ausgebildet, dass der üblicherweise in etwa in horizontaler Richtung aus der Beschichtungsvorrichtung 25 austretende Beschichtungsstrahl nach oben in Richtung der Absaugöffnung 3 umgelenkt wird. Hierdurch entsteht eine nach oben gerichtete Strömung, welche neben den Beschichtungsgasen auch die nicht auf das Werkstück aufgetragenen Beschichtungspartikel -Overspray- weitgehend mitreisst. Jedenfalls wird während des gesamten Beschichtungsvorgangs eine Gasströmung aufrechterhalten, indem über die Absaugöffnung 3 kontinuierlich abgesaugt wird.

Zusammenfassend kann festgehalten werden, dass mit der gezeigten Anordnung die heissen Overspraypartikel inkl. der sehr heissen Gase direkt am Werkstück 32 "gesammelt" und nach oben umgelenkt werden, wo sie über die Absaugöffnung 3 aus dem Tank 1a abgesaugt werden.

Die abgesaugten Overspraypartikel gelangen dann zusammen mit den heissen Gasen über die erste Absaugleitung 8 in die Filtervorrichtung 13, welche die Overspraypartikel abscheidet, ggf. mittels mehrerer Filter, beispielsweise mittels eines Grob- und eines nachgeschalteten Feinfilters. Auf diese Weise kann ein Grossteil der Overspraypartikel inkl. des Staubes sowie der heissen Gase vom Handhabungsgerät 24 abgehalten werden, wodurch höhere Leistungen über längere Zeiträume gefahren werden können. Ein weiterer Vorteil besteht darin, dass der Tank 1a zusammen mit dem Handhabungsgerät 24 und den weiteren Elementen 16, 25, 30 während eines Beschichtungsprozesses weniger verschmutzt wird. Obwohl die Abzugshaube 33 sehr nahe bzw. zentral an der Werkstückaufnahme angeordnet ist, ist die Werkstückaufnahme im herausgezogen Zustand der Plattform leicht zugänglich und kann daher einfach und schnell mit den zu beschichtenden Werkstücken bestückt werden.

Es versteht sich, dass das vorgängig anhand der Zeichnungen erläuterte Ausführungsbeispiel keinesfalls als abschliessend zu betrachten ist, sondern dass im Rahmen des in den Patentansprüchen definierten Schutzumfangs durchaus von dem erläuterten Ausführungsbeispiel abweichende Gestaltungen möglich sind. So sind beispielsweise abweichende Gestaltungen der Behandlungskammer, der Abzugshaube wie auch der Werkstückaufnahme und der Plattform möglich. So können beispielsweise innerhalb der Abzugshaube Leit- und/oder Umlenkbleche angeordnet werden, welche den Beschichtungsstrahl nach oben in Richtung der Absaugöffnung umlenken. Ggf. kann bei einem alternativen Ausführungsbeispiel beispielsweise auch nur eine Absaugleitung vorgesehen werden. Eine Alternative kann beispielsweise auch darin bestehen, dass die Absaugöffnung nicht in die Tankwand 1a eingelassen ist, sondern innerhalb des Tanks 1a angeordnet ist und innerhalb des Tanks 1a eine Absaugleitung zu dem zusätzlichen Flansch 7 (Fig. 1) führt, der auf der Oberseite der zweiten Stirnseite 5 des Tanks 1 a angeordnet ist. Dieser zusätzliche Flansch 7 würde dann über eine Leitung mit der Filtervorrichtung verbunden. Je nach Ausbildung und Anordnung der Werkstückaufnahme 29 bzw. des Tischs 30 könnte die Abzugshaube 33 ggf. auch an der Türe 2 angeordnet werden. Anstelle einer Abzugshaube mit einem rechteckigen Unterteil könnte deren Unterteil auch rund ausgebildet werden. Ein runder Unterteil ist vorzugsweise derart ausgebildet, dass dieser das Werkstück vorzugsweise zumindest um 180°, besonders bevorzugt um ca. 270° umschliesst, während das Werkstück bei rechteckiger Ausbildung der Abzugshaube von dieser vorzugsweise auf drei Seiten umschlossen wird. Die Werkstückaufnahme könnte beispielsweise auch in der Form eines linearen Satelliten ausgebildet sein.

## Patentansprüche

1. Anordnung zum Beschichten von Werkstücken, mit einer Behandlungskammer (1), in welcher eine Werkstückaufnahme (29) und ein eine Beschichtungsvorrichtung (25) tragendes Handhabungsgerät (24) angeordnet sind, wobei die Behandlungskammer (1) eine Absaugöffnung (3) zum Absaugen von heissen Gasen und/oder Beschichtungspartikeln aufweist, und wobei im Innenraum der Behandlungskammer (1) eine Abzugshaube (33) zum Kanalisieren der abzusaugenden Gase in Richtung der Absaugöffnung (3) angeordnet ist, **dadurch gekennzeichnet, dass** zumindest die Abzugshaube (33) zusammen mit der Werkstückaufnahme (29) auf einer verschiebbaren Plattform (16) angeordnet sind, mittels welcher die Abzugshaube (33) zusammen mit der Werkstückaufnahme (29) aus der Behandlungskammer (1) herausziehbar bzw. in die Behandlungskammer (1) hineinschiebbar ist, wobei die Abzugshaube (33) derart auf der Plattform (16) angeordnet ist, dass im hineingeschobenen Zustand der Plattform (16) die Abzugshaube mit der Absaugöffnung (3) gekoppelt ist.

2. Anordnung nach Anspruch 1, **dadurch gekennzeichnet, dass** die Absaugöffnung (3) auf der Oberseite der Behandlungskammer (1) angeordnet ist.

3. Anordnung nach Anspruch 1 oder 2, **dadurch gekennzeichnet, dass** die Abzugshaube (33) mit einer der Beschichtungsvorrichtung (25) zugewandten Öffnung (35) versehen ist.

4. Anordnung nach einem der vorhergehenden Ansprüche, **dadurch gekennzeichnet, dass** die Abzugshaube (33) auf der Oberseite mit einem Anschlussflansch (4) zum Koppeln mit der Absaugöffnung (3) versehen ist.

5. Anordnung nach einem der vorhergehenden Ansprüche, **dadurch gekennzeichnet, dass** die Werkstückaufnahme (29) als drehbarer Tisch (30) ausgebildet ist und Mittel zum Fixieren eines oder mehrerer Werkstücke (32, 32a) aufweist, und dass die Abzugshaube (33) drehfest auf der Plattform (16) angeordnet ist.

6. Anordnung nach Anspruch 5, **dadurch gekennzeichnet, dass** die Abzugshaube (33) in Bezug auf den Tisch (30) derart angeordnet ist, dass das zu beschichtende Werkstück (32) zwischen der Beschichtungsvorrichtung (25) und der Eintrittsöffnung (35) der Abzugshaube (33) oder in der Abzugshaube (33) hinter der Eintrittsöffnung (35) auf dem Tisch (30) fixierbar ist.

7. Anordnung nach Anspruch 5 oder 6, **dadurch gekennzeichnet, dass** der Tisch (30) zur Aufnahme einer Mehrzahl von Werkstücken (32, 32a) ausgebildet ist, welche entlang eines kreisringförmigen Aussenteils (31) fixierbar sind, und dass die Abzugshaube (33) drehfest und zentral innerhalb bzw. oberhalb des kreisringförmigen Aussenteils (31) angeordnet ist.

8. Anordnung nach einem der vorhergehenden Ansprüche, **dadurch gekennzeichnet, dass** die Behandlungskammer (1) durch einen Tank (1 a) gebildet ist, der mittels einer Vakuumpumpe (14) evakuierbar ist.

9. Anordnung nach einem der vorhergehenden Ansprüche, **dadurch gekennzeichnet, dass** die eine Stirnseite des Tanks (1 a) als Türe (2) ausgebildet ist, über welche die Plattform (16) aus dem Tank (1a) herausziehbar bzw. in den Tank (1a) hineinschiebbar ist.

10. Anordnung nach einem der vorhergehenden Ansprüche, **dadurch gekennzeichnet, dass** die Plattform (16) auf einer Schiene (20, 21) verfahrbar abgestützt.

11. Anordnung nach Anspruch 10, **dadurch gekennzeichnet, dass** sowohl innerhalb wie auch ausserhalb der Behandlungskammer (1) eine Schiene (20, 21) angeordnet ist, wobei die ausserhalb der Behandlungskammer (1) angeordnete Schiene (21) vertikal unterhalb der innerhalb der Behandlungskammer (1) angeordneten Schiene (20) verläuft, und wobei die Plattform (16) einen mit Rollen (18) versehenen Schwenkmechanismus (19) aufweist, der beim Herausziehen der Plattform (16) aus der Behandlungskammer (1) derart nach unten schwenkt, dass die Rollen (18) auf der ausserhalb der Behandlungskammer (1) angeordneten Schiene (21) aufzuliegen kommen.

12. Verfahren zum Beschichten von Werkstücken in einer Behandlungskammer (1), in welcher ein Handhabungsgerät (24) und eine Werkstückaufnahme (29) zum Fixieren eines oder mehrerer zu beschichtender Werkstücke (32, 32a) angeordnet sind, wobei das Handhabungsgerät (24) eine Beschichtungsvorrichtung (25) zum Beschichten der Werkstücke trägt und die Behandlungskammer (1) zumindest eine Absaugöffnung (3) zum Absaugen von heissen Gasen und/oder Beschichtungspartikeln aufweist, und wobei im Innenraum der Behandlungskammer (1) eine Abzugshaube (33) zum Kanalisieren der abzusaugenden Gase in Richtung der Absaugöffnung (3) angeordnet ist, und wobei zumindest die Abzugshaube (33) zusammen mit der Werkstückaufnahme (29) auf einer verschiebbaren Plattform (16) angeordnet sind, **dadurch gekennzeichnet, dass** die Plattform (16) zusammen mit der Werkstückaufnahme (29) und der Abzugshaube (33) aus der Behandlungskammer (1) herausgezogen wird und danach ein Werkstück oder mehrere Werkstücke an der Werkstückaufnahme (29) befestigt wird/werden, dass die Plattform (16) danach zusammen mit der Werkstückaufnahme (29) und der Abzugshaube (33) soweit in die Behandlungskammer (1) hineingeschoben wird, bis die Abzugshaube (33) mit der Absaugöffnung (3) gekoppelt ist.

13. Verfahren nach Anspruch 12, **dadurch gekennzeichnet, dass** während des Beschichtens eines Werkstücks (32) Gase über die Abzugshaube (33) und die Absaugöffnung (3) aus der Behandlungskammer (1) abgesaugt werden.

14. Verfahren nach Anspruch 13, wobei die Werkstückaufnahme (29) als drehbarer Tisch (30) ausgebildet ist, **dadurch gekennzeichnet, dass** das zu beschichtende Werkstück (32) derart auf dem Tisch (30) angeordnet wird, dass beim Beschichten des jeweiligen Werkstücks (32) der Beschichtungsstrahl (27) zum Beschichten des Werkstücks (32) überwiegend horizontal oder nach oben gerichtet ist.

15. Verfahren nach Anspruch 13 oder 14, **dadurch gekennzeichnet, dass** der Absaugvorgang spätestens mit dem Beginn eines Beschichtungsvorgangs gestartet wird, wobei in der Behandlungskammer (1) während des gesamten Beschichtungsvorgangs eine kontinuierliche Gasströmung erzeugt wird, welche vom Kopf (26) der Beschichtungsvorrichtung (25) ausgehend nach oben in Richtung der Absaugöffnung (3) gerichtet ist.
